# EUROPEAN PATENT APPLICATION

(11) **EP 0 827 025 A1**
(43) Date of publication of application: **04.03.1998**
(21) Application number: 97114663.4
(22) Date of filing: 25.08.1997
(51) Int. Cl.: G03F 7/038, G03F 7/004

(54) **Negative resist composition**

(30) Priority: 26.08.1996 JP 223780/96
(71) Applicant: SUMITOMO CHEMICAL COMPANY, LIMITED, Chuo-ku Osaka 541 (JP)
(72) Inventor: Suetsugu, Masumi, Minoo-shi, Osaka (JP); Kusumoto, Takehiro, Osaka-shi, Osaka (JP); Takeyama, Naoki, Settu-shi, Osaka (JP)
(74) Representative: VOSSIUS & PARTNER

(57) **Abstract**

A negative resist composition comprising an alkaline-soluble resin containing a polyvinylphenol resin whose phenolic hydroxyl group is partially alkyl-etherified, a sulfonate of a N-hydroxyimide compound as an acid generator, and a crosslinking agent, wherein a dispersion degree of the polyvinylphenol resin determined by gel permeation chromatography is within the range from 1.01 to 2, and using the negative resist composition, resolution and profile are improved.

## Description

The present invention relates to a negative resist composition suitable for lithography which uses far ultraviolet light (including excimer laser, etc.), electron beam, X-ray or radiation.

With getting higher integration of integrated circuits in recent years, formation of a pattern of a submicron order has been required. Excimer laser lithography has attracted special interest because it makes it possible to produce 64 MDRAM (mega-bit Dynamic RAM) and 256 MDRAM. As a resist suitable for excimer laser lithography, a so-called chemical amplification type resist utilizing chemical amplification effects of an acid catalyst has been suggested. The chemical amplification negative type resist reduces the solubility to a developing solution of an alkaline soluble resin at the exposed part by crosslinking caused by an crosslinking agent and an acid generated from an acid generator due to irradiation, while the solubility of an alkaline soluble resin at the unexposed part is maintained because no acid is generated. Based on the mechanism, a negative pattern is obtained by the formation of a resist film, irradiation for patterning and the development with an alkaline solution.

As the chemical amplification positive resist, a polyvinylphenol resin has often been used. However, the polyvinylphenol resin has too high solubility to the alkaline developer and a sufficient sensitivity and resolution cannot be obtained. In order to solve these problems, use of a polyvinylphenol resin whose phenolic hydroxyl group is partially alkyl-etherified is disclosed in JP-A-7-295220. Although using the polyvinylphenol resin disclosed in JP-A-7-295220, sensitivity and resolution are improved, more improved resolution and improvement of profile(form of pattern) are still desired.

An object of the present invention is to provide a negative resist composition which is superior in resolution and profile and is also superior in sensitivity, film retention and application properties.

That is, the present invention provides a negative resist composition comprising an alkaline-soluble resin containing a polyvinylphenol resin whose phenolic hydroxyl group is partially alkyl-etherified, a sulfonate of a N-hydroxyimide compound as an acid generator, and a crosslinking agent, wherein the dispersion degree (Mw/Mn) of the polyvinylphenol resin determined by gel permeation chromatography is within the range from 1.01 to 2.

The alkaline-soluble resin used in the present invention is a polyvinylphenol resin whose phenolic hydroxyl group is partially alkyl-etherified. The term "polyvinylphenol resin" used herein means a polymer comprising repeating units which have a benzene ring and a hydroxyl and vinyl group bonded to the benzene ring, i.e. a polymer comprising vinylphenol as a constituent monomer. Specific examples thereof include polyvinylphenol as a homopolymer of vinylphenol, copolymer of vinylphenol and another vinyl compound, and a partially hydrogenated one thereof. The position of the hydroxyl group and vinyl group on the benzene ring of vinylphenol is not specifically limited, but p-vinylphenol is generally preferred. When using a partially hydrogenated polyvinylphenol or a partially hydrogenated copolymer containing vinylphenol, the proportion of double bonds of the benzene ring saturated by hydrogenation (hydrogenation degree) is generally not more than 50%, preferably not more than 15%.

In the polyvinylphenol resin whose phenolic hydroxyl group is partially alkyl-etherified (hereinafter referred to as "partially alkyl-etherified polyvinylphenol resin*"*), the alkyl preferably has 1 to 4 carbon atoms. When the number of carbon atoms of the alkyl is not less than 3, the alkyl may be a straight-chain or branched alkyl. It is particularly preferred that the alkyl is methyl or ethyl. The proportion of alkyl-etherified phenolic hydroxyl groups of the polyvinylphenol resin per the total phenolic hydroxyl groups (etherification degree) is preferably within the range from 5 to 40%, particularly preferably from 15 to 25%. The partial alkyl etherification can be conducted, for example, by reacting polyvinylphenol resin with an alkyl halide under the basic condition according to the method described in N. Rabjohn et al., "Organic Syntheses Collective Volume 4", pp. 836-839, John Wiley & Sons (1963).

The weight-average molecular weight of the partially alkyl-etherified polyvinylphenol resin determined by gel permeation chromatography (GPC) and calculated as polystyrene is preferably within the range from 1,500 to 35,000. The weight-average molecular weight is preferably from 2,000 to 32,000, more preferably not more than 20,000, particularly preferably not more than 8,000. The weight-average molecular weight of the partially alkyl-etherified polyvinylphenol resin can be adjusted within the above range by adjusting the weight-average molecular weight of polyvinylphenol resin before alkyl etherification within a range a little lower than the above range, e.g. within the range from 1,500 to 30,000.

It is important that the dispersion degree of this resin, that is, ratio of the weight-average molecular weight (Mw) to the number-average molecular weight (Mn), which are respectively determined by GPC (calculated as polystyrene), is within the range from 1.01 to 2, preferably not more than 1.8. By using such a resin whose dispersion degree is small, the transmittance of the resist is improved and a pattern having excellent resolution and profile can be obtained.

The partially alkyl-etherified polyvinylphenol resin having the dispersion degree of 1.01 to 2 can be produced from a polyvinylphenol resin having the dispersion degree of 1.01 to 2. Such a polyvinylphenol resin whose dispersion degree is small can be obtained, for example, by a living polymerization.

The partially alkyl-etherified polyvinylphenol resin can be used alone or in combination thereof, as the alkaline-soluble resin in the resist composition of the present invention. Furthermore, another alkaline-soluble resin can be mixed with the partially alkyl-etherified polyvinylphenol resin unless the effect of the present invention is not damaged. Examples of the other resin which can be mixed with the partially alkyl-etherified polyvinylphenol resin include polyvinylphenol resin, polyisopropenylphenol resin, copolymer of vinylphenol and styrene (the proportion of vinylphenol is preferably not less than 50% by mol), copolymer of isopropenylphenol and styrene (the proportion of isopropenylphenol is preferably not less than 50% by mol) and a partially hydrogenated polyvinylphenol resin. When the other alkaline-soluble resin is mixed, it is preferred that the other resin to be mixed also has small dispersion degree.

The resist composition of the present invention comprises a sulfonate of a N-hydroxyimide compound as the acid generator, in addition to the above alkaline-soluble resin. One kind of the sulfonate of N-hydroxyimide compounds can be used alone or two or more kinds of the sulfonate of N-hydroxyimide compounds can be used in combination as the acid generator. Examples of the sulfonate of the N-hydroxyimide compound include those represented by the general formula (I): 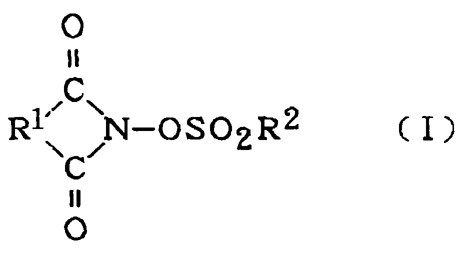 wherein R¹ represents an arylene, an alkylene which may be optionally substituted or an alkenylene which may be optionally substituted; and R² represents an alkyl which may be optionally substituted with a substituent other than fluorine or an aryl containing no fluorine.

The arylene represented by R¹ can be phenylene, naphthylene and the like, and these naphthylene and phenylene may be unsubstituted or substituted. Examples of the substituent of the phenylene and naphthylene include alkyl having 1 to 4 carbon atoms, alkoxy having 1 to 4 carbon atoms, halogen such as fluorine, chlorine, bromine and iodine, nitro, and acetylamino. As the phenylene, 1,2-phenylene is preferred. As the naphthylene, 1,2-, 2,3- or 1,8-naphthylene is preferred.

The alkylene represented by R¹ can be those having about 1 to 6 carbon atoms, and may be unsubstituted or substituted. The alkylene having 2 or more carbon atoms may be a straight-chain or branched alkylene. Examples of the preferred alkylene include ethylene, 1,2-propylene and 1,3-trimethylene. Examples of the substituent of the alkylene include halogen such as fluorine, chlorine, bromine and iodine, alkoxy having 1 to 4 carbon atoms, unsubstituted phenyl and phenyl substituted with the substituent such as alkyl having 1 to 4 carbon atoms, alkoxy having 1 to 4 carbon atoms, halogen, nitro or acetylamino.

The alkenylene represented by R¹ can be those having about 2 to 4 carbon atoms, and may be unsubstituted or substituted. The alkenylene may be straight-chain or branched alkenylene. Preferred examples of the alkenylene include vinylene. Examples of the substituent of the alkenylene include unsubstituted phenyl and phenyl substituted with a substituent such as alkyl having 1 to 4 carbon atoms, alkoxy having 1 to 4 carbon atoms, halogen, nitro or acetylamino.

The alkyl represented by R² can be those having about 1 to 12 carbon atoms, and may be unsubstituted or substituted. The alkyl having 3 or more carbon atoms may be a straight-chain, branched or cyclic alkyl, preferably a straight-chain alkyl or alkyl having a cyclic moiety which may be a crosslinked ring. Examples of the substituent of the alkyl include halogen other than fluorine, alkoxy having 1 to 4 carbon atoms, oxo (=O), unsubstituted phenyl and phenyl substituted with a substituent such as alkyl having 1 to 4 carbon atoms, halogen other than fluorine, nitro or acetylamino.

The aryl represented by R² can be phenyl, naphthyl and the like, and these phenyl and naphthyl may be unsubstituted or substituted. Examples of the substituent of the phenyl and naphthyl include alkyl having 1 to 4 carbon atoms, alkoxy having 1 to 4 carbon atoms, halogen other than fluorine , nitro and acetylamino. As the aryl represented by R², monocyclic one, i.e. unsubstitured or substituted phenyl is preferred.

The sulfonate represented by the general formula (I) can be produced, for example, by reacting imide N-hydroxydicarboxylate produced according to the method described in G.F. Jaubert, Ber. Dtsch. Chem. 28, 360 (1985), D.E. Ames et al., J. Chem. Soc., 3518 (1995) or M.A. Stolberg et al., J. Amer. Chem. Soc., 79, 2615 (1957) with an alkyl or arylsulfonyl chloride under the basic condition according to the method described in L. Bauer. et al., J. Org. Chem. 24. 1293 (1959).

Examples of the preferred sulfonate represented by the general formula (I) include the followings:

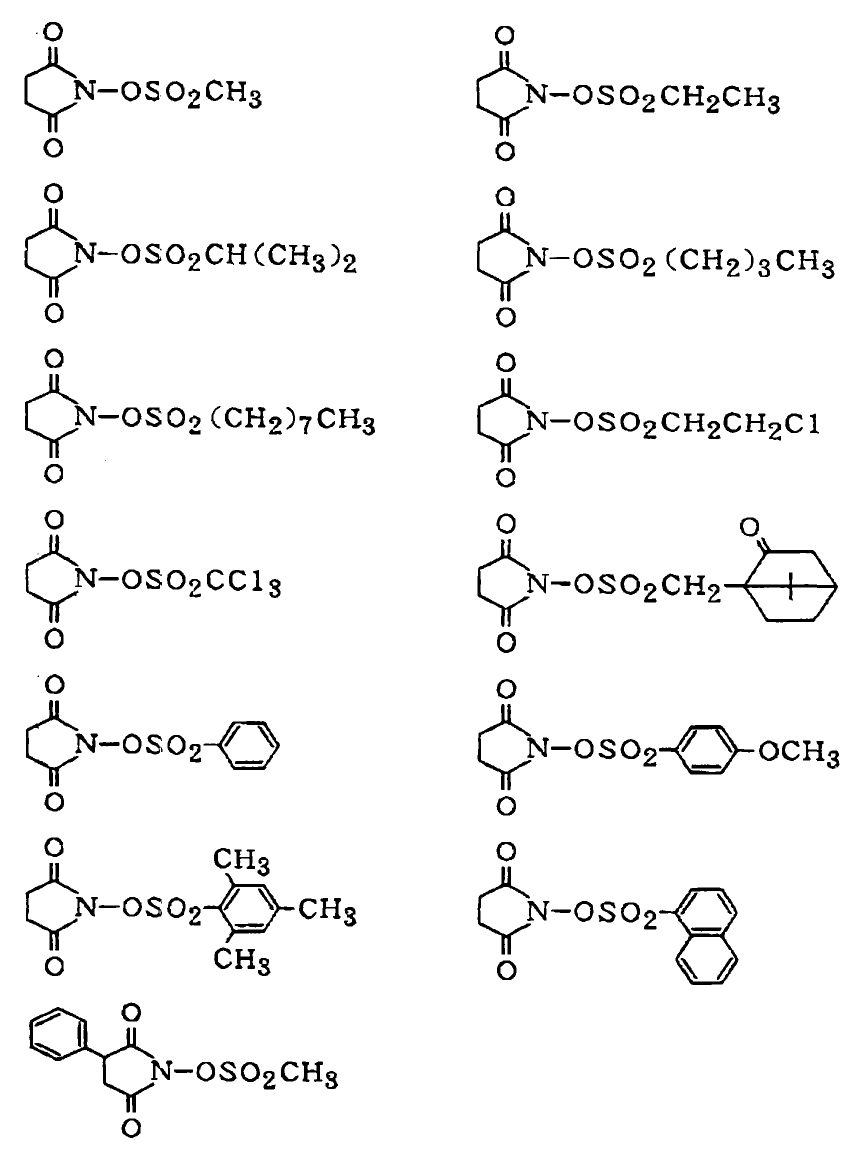

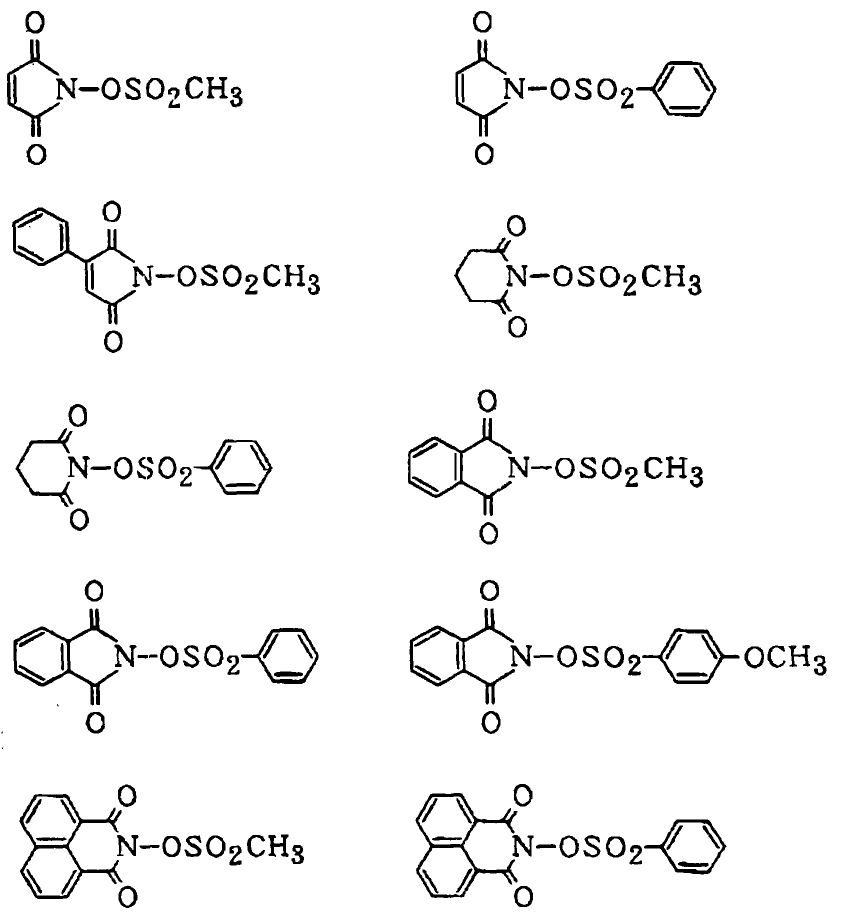

The crosslinking agent used in the present invention may be any one which reacts with an acid generated from the acid generator to make the aforementioned alkaline-soluble resin cause a crosslinking reaction, and is not specifically limited. Preferably, a compound having a methylol group or a methylol ether group is used. One kind of the crosslinking agent can be used alone or two or more kinds of the crosslinking agent can be used in combination. Examples of the crosslinking agent having the methylol group or methylol ether group include those described in JP-A-1-293339 and 5-210239. Among them, preferred crosslinking agents are as follows.

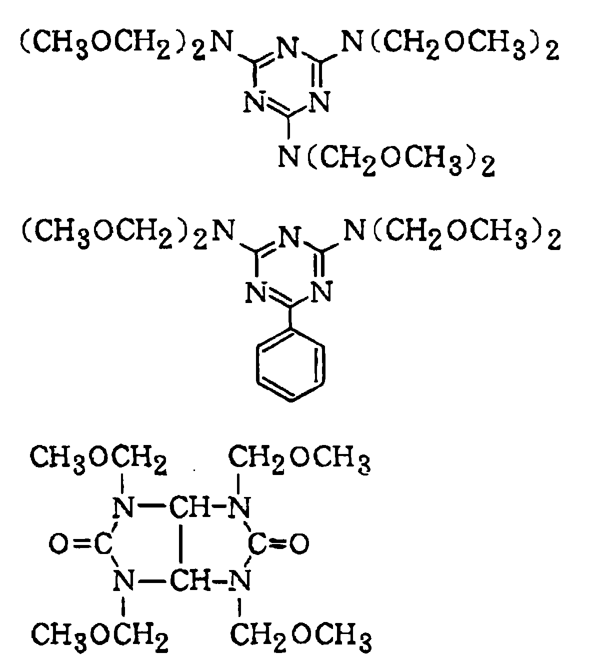

The preferred composition ratio of the negative resist composition according to the present invention is as follows. That is, the alkaline-soluble resin, acid generator and crosslinking agent are used in the amount within the range from 20 to 95% by weight, from 0.1 to 25% by weight and from 1 to 30% by weight, respectively, based on the weight of the total solid content in this composition. If necessary, the negative resist composition of the present invention can contain various additives which are normally used in this filed, such as sensitizers, dyes and adhesive modifiers.

A negative resist composition of the present invention is prepared by mixing the above respective components with a solvent so that the concentration of the total solid content in this negative resist composition is within the range from 10 to 50% by weight. The negative resist composition thus prepared is then applied on a substrate such as silicon wafer. The solvent used may be any one which can dissolve the respective components and may be those which are normally used in this field. Examples thereof include glycol ether esters such as ethylcellosolve acetate, methylcellosolve acetate, propylene glycol monomethyl ether acetate and propylene glycol monoethyl ether acetate; glycol mono- or diethers such as ethylcellusolve, methylcellosolve, propylene glycol monomethyl ether, propylene glycol monoethyl ether and diethylene glycol dimethyl ether; esters such as ethyl lactate, butyl acetate and ethyl pyruvate; ketones such as 2-heptanone, cyclohexanone and methyl isobutyl ketone; and aromatic hydrocarbons such as xylene. These solvents can be used alone or in combination thereof.

The resist composition of the present invention gives excellent resolution and good profile in an exposure using far ultraviolet light (including excimer laser, etc.), electron beam, X-ray or radiation, and is also superior in sensitivity, film retention and application properties. Accordingly, in the lithography using the above light source, the resolution and contrast can be remarkably improved and a fine resist pattern can be formed with high accuracy.

The following Examples further illustrate the present invention.

In the Examples, "parts" are by weight unless otherwise stated.

### Reference Example 1 (Ethyl etherification of polyvinylphenol)

Poly(p-vinylphenol) ["VP-5000" manufactured by Nippon Soda Co., Ltd., weight-average molecular weight: 6,500, dispersion degree: 1.28] (25.0 g) was dissolved in 125 ml of acetone, and potassium carbonate (11.5 g) and ethyl iodide (6.49 g) were added, and then the mixture was refluxed for 9 hours. After the reaction solution was filtered, the filtrate was added dropwise to 2 liter of an aqueous acetic acid solution (pH 3) to perform reprecipitation and the precipitate was collected by filtration. After the resin obtained by filtration was dried at 60°C, it was mixed with acetone and hexane so that a volume ratio of a 20 wt% acetone solution of this resin to hexane becomes 2:1. This mixed solution was stirred at room temperature for 1 hour, and then the acetone layer was taken up. This acetone layer was added and mixed in 2 liter of a deionized water and the solid formed was collected by filtration to obtain poly(p-vinylphenol) wherein 15.9% of hydroxyl groups were ethyl-etherified. This resin had a weight-average molecular weight of 7,700 and a dispersion degree of 1.63.

### Reference 2 (Ethyl etherification of polyvinylphenol)

Poly(p-vinylphenol) ["VP-2500" manufactured by Nippon Soda Co., Ltd., weight-average molecular weight: 3,500, dispersion degree: 1.39] (25.0 g) was dissolved in 125 ml of acetone, and potassium carbonate (11.5 g) and ethyl iodide (6.49 g) were added, and then the mixture was refluxed for 9 hours. After the reaction solution was filtered, the filtrate was added dropwise to 2 liter of an aqueous acetic acid solution (pH 3) to perform reprecipitation and the precipitate was collected by filtration. After the resin obtained by filtration was dried at 60°C, it was mixed with acetone and hexane so that a volume ratio of a 20 wt% acetone solution of this resin to hexane becomes 2:1. This mixed solution was stirred at room temperature for 1 hour, and then the acetone layer was taken up. This acetone layer was added and mixed in 2 liter of a deionized water and the solid was collected by filtration to obtain poly(p-vinylphenol) wherein 19.3% of hydroxyl groups were ethyl-etherified. This resin had a weight-average molecular weight of 3,900 and a dispersion degree of 1.75.

### Reference 3 (the same as the above)

The same operation as that of Reference Example 2 was conducted except for changing the amount of potassium carbonate and ethyl iodide to 10.3 g and 5.81 g, respectively. Poly(p-vinylphenol) wherein 16.9% of hydroxyl groups were ethyl-etherified was obtained. This resin had a weight-average molecular weight of 3,700 and a dispersion degree of 1.72.

### Example 1

The resin synthesized in Reference Example 1 (20.1 parts), hexamethylolmelamine hexamethyl ether (1.5 parts) as a crosslinking agent and ethanesulfonate of N-hydroxysuccinimide (1.2 parts) as an acid generator were dissolved in propylene glycol monomethyl ether acetate (93.5 parts). The resulting solution was filtered through a fluororesin filter having a pore diameter of 0.1 µm to prepare a resist solution.

The above resist solution was coated on a silicon wafer, which was washed according to a normal procedure, using a spin coater, so that a film thickness after drying becomes 0.7 µm. Then, this silicon water was prebaked on a hot plate at 100°C for 60 seconds. Incidentally, the transmittance at 248 nm of this coated film was 70% (0.7 µm). The film after prebaking was exposed through a chrome mask having a pattern using a KrF excimer laser stepper having an exposure wavelength of 248 nm ["NSR-1755 EX8A" manufactured by Nikon Co. Ltd., NA: 0.45] while an exposure dose was stepwisely changed. After completion of the exposure, the wafer was heated on the hot plate at 110°C for 60 seconds (post exposure bake). The resultant was developed with an aqueous 2.38 wt% solution of tetramethylammonium hydroxide to obtain a negative pattern.

The formed pattern was observed using an election microscope to determine an exposure dose (effective sensitivity) at which a cross section of a 0.25 µm line/space pattern becomes 1:1. As a result, it was 20 mJ/cm². A width of a minimum line/space which separates at the exposure dose of the effective sensitivity without causing film thickness reduction (resolution) was 0.24 µm. A profile (form of pattern) was good. A wall of the formed pattern was vertical.

### Examples 2

The same operation as that described in Example 1 was conducted except for using the same amount of the resin synthesized in Reference Example 2 in place of the resin synthesized in Reference Example 1. The effective sensitivity was 48 mJ/cm² and the resolution was 0.22 µm. The profile was good and the wall was vertical.

### Examples 3

The same operation as that described in Example 1 was conducted except for using the same amount of the resin synthesized in Reference Example 3 in place of the resin synthesized in Reference Example 1. The effective sensitivity was 59 mJ/cm² and the resolution was 0.22 µm. The profile was good and the wall was vertical.

### Examples 4

The same operation as that described in Example 1 was conducted except for using n-butanesulfonate of N-hydroxysuccinimide in place of ethanesulfonate of N-hydroxysuccinimide. The effective sensitivity was 45 mJ/cm² and the resolution was 0.22 µm. The profile was good and the wall was vertical.

### Reference 4 (ethyl etherification of polyvinylphenol having large dispersion degree)

Poly(p-vinylphenol) ["LinkerM S-2P" manufactured by Maruzen Sekiyu Kagaku Co., Ltd., weight-average molecular weight: 6,700, dispersion degree: 3.37] (25.0 g) was dissolved in 100 ml of acetone, and potassium carbonate (15.6 g) and ethyl iodide (6.49 g) were added. Then the mixture was refluxed for 9.5 hours. After the reaction solution was filtered, the filtrate was added dropwise to 2 liter of an aqueous acetic acid solution (pH 3) to perform reprecipitation and the precipitate was collected by filtration. After the resin obtained by filtration was dried at 60°C, it was mixed with acetone and hexane so that a volume ratio of a 20 wt% acetone solution of this resin to hexane becomes 2:1. This mixed solution was stirred at room temperature for 1 hour, and then the acetone layer was taken up. This acetone layer was added and mixed in 2 liter of a deionized water and the solid was collected by filtration to obtain poly(p-vinylphenol) wherein 18.7% of hydroxyl groups were ethyl-etherified. This resin had a weight-average molecular weight of 7,400 and a dispersion degree of 3.33.

### Comparative Example 1

The same operation as that of Example 1 was conducted except for using the same amount of the resin synthesized in Reference Example 4 in place of the resin synthesized in Reference Example 1. The effective sensitivity was 42 mJ/cm² and the resolution was 0.24 µm. The profile slightly overhung wherein the upper portion is thick. Incidentally, the transmittance at 248 nm of the coated film after prebaking was 46% (0.7 µm).

### Comparative Example 2

The same operation as that of Example 4 was conducted except for using the same amount of the resin synthesized in Reference Example 4 in place of the resin sythesized in Reference Example 1. The effective sensitivity was 57 mJ/cm² and the resolution was 0.25 µm. The profile slightly overhung wherein the upper portion is thick.

## Claims

1. A negative resist composition comprising an alkaline-soluble resin containing a polyvinylphenol resin whose phenolic hydroxyl group is partially alkyl-etherified, a sulfonate of a N-hydroxyimide compound as an acid generator, and a crosslinking agent, wherein the dispersion degree of the polyvinylphenol resin determined by gel permeation chromatography is within the range from 1.01 to 2.

2. The composition according to claim 1, wherein 5 to 40% of the phenolic hydroxyl groups of the polyvinylphenol resin are alkyl-etherified.

3. The composition according to claim 1 or 2, wherein the sulfonate of the N-hydroxyimide compound is represented by the general formula (I): 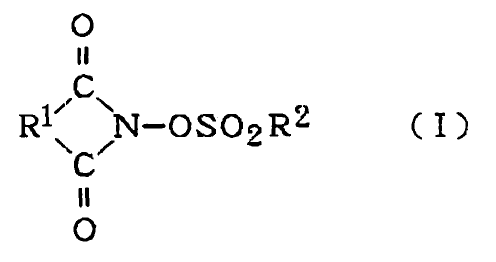 wherein R¹ represents an arylene, an alkylene which may be optionally substituted or an alkenylene which may be optionally substituted; and R² represents an alkyl which may be optionally substituted with a substituent other than fluorine or an aryl containing no fluorine.

4. The composition according to any one of claims 1 to 3, comprising the alkaline-soluble resin, the acid generator and the crosslinking agent in an amount of 20 to 95% by weight, 0.1 to 25% by weight and 1 to 30% by weight, respectively, based on the weight of the total solid content of the composition.
